# EUROPÄISCHE PATENTSCHRIFT

(11) **EP 3 980 800 B1**
(45) Veröffentlichungstag und Bekanntmachung des Hinweises auf die Patenterteilung: **02.08.2023**
(21) Anmeldenummer: 20729613.8
(22) Anmeldetag: 08.05.2020
(51) Int. Cl.: G01R 33/34, G01R 33/48, H01Q 9/26, H01Q 9/42, H01Q 21/06, H01Q 21/20

(54) **VERWENDUNG EINES DIPOLANTENNEN-ARRAYS IN HYBRIDES MR-PET UND MR-SPECT TOMOGRAPHEN SOWIE MR-PET ODER MR-SPECT TOMOGRAPH MIT EINEM DIPOLANTENNEN-ARRAY**
USE OF A DIPOLE ANTENNA ARRAY FOR HYBRID MR-PET AND MR-SPECT SCANS AND MR-PET OR MR-SPECT TOMOGRAPH WITH A DIPOLE ANTENNA ARRAY
UTILISATION D'UN RÉSEAU D'ANTENNES DIPÔLES POUR TOMOGRAPHES RM-PET ET RM-SPECT HYBRIDES ET TOMOGRAPHE RM-PET OU RM-SPECT COMPRENANT UN RÉSEAU D'ANTENNES DIPÔLES.

(30) Priorität: 06.06.2019 DE 102019003949
(43) Veröffentlichungstag der Anmeldung: 13.04.2022
(73) Patentinhaber: Forschungszentrum Jülich GmbH, 52425 Jülich (DE)
(72) Erfinder: CHOI, Chang-Hoon, 52428 Jülich (DE); FELDER, Jörg, 52428 Jülich (DE); HONG, Suk Min, 52146 Würselen (DE); LERCHE, Christoph, 52134 Herzogenrath (DE); SHAH, Nadim Joni, 52428 Jülich (DE)
(86) Internationale Anmeldenummer: PCT/DE2020/000092
(87) Internationale Veröffentlichungsnummer: WO 2020/244689

(56) Entgegenhaltungen:
- WO-A1-2013/159053
- DE-B3- 10 322 186
- GB-A- 1 322 300
- US-A1- 2017 164 915
- NIKOLAI I. AVDIEVICH ET AL: "Evaluation of short folded dipole antennas as receive elements of ultra-high-field human head array", MAGNETIC RESONANCE IN MEDICINE., Bd. 82, Nr. 2, 7. April 2019 (2019-04-07), Seiten 811-824, XP055718377, US ISSN: 0740-3194, DOI: 10.1002/mrm.27754

## Beschreibung

Die Erfindung betrifft die Verwendung eines Dipolantennen-Arrays für hybride MR-PET und MR-SPECT Tomographen, sowie einen MR-PET oder MR-SPECT Tomographen mit einem Dipolantennen-Array.

Für kernmagnetische Resonanzaufnahmen mit hybriden MR-PET oder MR-Spect Geräten werden Hochfrequenz-Antennen eingesetzt, welche in der Magnetbohrung und damit im PET oder SPECT Messbereich positioniert sind. Bei den kombinierten Verfahren, bei denen die MRT- Aufnahmen zeitgleich mit PET- oder SPECT-Aufnahmen gemacht werden, besteht der Bedarf, die Messanteile, die aus dem PET- bzw. SPECT-Anteil resultieren möglichst störungsfrei zu erhalten.

Die MRT-Spulen, dienen dem Senden und/oder Empfangen hochfrequenter elektromagnetischer Strahlung. Sie arbeiten üblicherweise im Nahfeld der Antenne, bei Hochfeld-MRT auch im Übergangsbereich zwischen Nah- und Fernfeld, sodass leitende Strukturen nämlich Antennen in der Nähe des Untersuchungsvolumens angeordnet werden müssen.

Kombination von MRT und PET oder SPECT- Systemen bieten den Vorteil zeitgleiche Messungen von zwei oder mehreren Modalitäten zu ermöglichen. Technisch werden sie durch die Integration von Szintillationskristallen und eventuell der Auswerteelektronik in der Magnetbohrung eines MRT- Systems realisiert. Um Sensitivtätseinbußen der MRT- Messungen gering zu halten, erfordern kombinierte MR-PET oder MR-SPECT- Systeme die Anordnung von MRT- Antennen, die oftmals auch als MRT- Spulen bezeichnet werden innerhalb eines PET-/SPECT Detektorrings. Hierdurch ist eine starke Kopplung der in der MRT verwendeten magnetischen Felder mit der PET/SPECT Detektoreinheit einerseits, und eine Absorption der GammaQuanten der PET/SPECT Messung durch die eingebrachte Antenne andererseits verbunden.

PET und SPECT beziehen ihre Signale aus Annihilationsquanten, nämlich γ-Quanten einer Energie von üblicherweise 511 keV. Diese werden entlang ihres zurückgelegten Weges durch Materie in ihrem Ausbereitungsweg absorbiert oder gestreut. Aus diesem Grund wirkt sich das Einbringen einer MRT Spule in ein PET/SPECT System negativ auf die Sensitivität der PET/SPECT Messung aus.

Aufgrund der Wellenlänge in MRT's nach dem Stand der Technik, welche in klinisch zugelassenen Geräten mit maximal 7 T, oder auch 1,5 und 3 T, arbeiten, was einer Resonanzfrequenz von ca. 300 MHz (7T), 128 MHz (3T), bzw. 64 MHz (1,5T) für Protonen entspricht, sind gerade Dipole zu lang, um eine effiziente Ankopplung zu dem Untersuchungsvolumen zu gewährleisten. Daher werden zur Verkürzung der verwendeten Dipolantennen Bauteile, z.B. Induktivitäten, in die Dipolantenne eingefügt, wie es in "Kurze Antennen: Entwurf und Berechnung verkürzter Sende- und Empfangsantennen" Franckh, 1986 S.408, ISBN 3440054691 beschrieben ist. Die so verkürzten Dipolantennen werden üblicherweise ebenfalls in der Dipolmitte angeschlossen. Alle diese Maßnahmen führen jedoch zu zusätzlicher Absorption bzw. Streuung der PET/SEPCT γ-Quanten durch hoch absorbierendes Material, wie elektronische Bauteile und zusätzliche Leiterstrukturen im PET/SPECT Messvolumen. Der Mittenanschluss des Dipolelements fügt weitere Bauteile, wie Koaxialleitungen und konzentrierte Bauteile in den PET/SPECT sensitiven Bereich. In der MRT wirkt sich die Verwendung langer Dipolelemente in zweifacher Hinsicht negativ aus. Zum einen beschränken sie das Messvolumen - z. B. können zylinderförmige Anordnungen von Dipolen mit geringem Durchmesser wie für die Kopfbildgebung erwünscht durch die verbreiterte Anatomie im Schulterbereich geometrisch begrenzt sein. Weiterhin führen gerade Dipolantennen zu einem großen sensitiven Bereich entlang der Magnetachse, welcher oftmals über den homogenen Bereich der schaltbaren Gradienten Felder hinausgeht, und damit zu Signaleinfaltungen in den MRT Bildern führen kann.

MRT Antennen müssen eine möglichst geringe Gammaquanten Absorption für Quanten im PET und/oder SPECT Energiebereich aufweisen, um die Sensitivität der nuklearmedizinischen Modalität nicht zu verringern.

Das deutsche Patent DE 103 22 186 B3 offenbart eine Dipolantenne, die gefaltet ist und die in der Faltung einen Anschluss besitzt.

Bei Messungen in MR-PET oder MR-SPECT Geräten besteht daher der Bedarf, möglichst geringe Materialmengen in das Untersuchungsvolumen bzw. den räumlichen Messbereich einzubringen. Es besteht der Bedarf die Qualität von MRT-PET/SPECT-Messungen zu verbessern und mit den kombinierten MR-PET/SPECT Geräten annähernd identische Qualität zu den Messungen mit den getrennten Komponenten MRT, PET und SPECT zu erhalten.

Es ist daher die Aufgabe der Erfindung eine Aufnahme von MR-PET bzw. MR-SPECT Daten zu ermöglichen, welche besonders störungsfrei ist, bzw. eine möglichst geringe Reduktion der Sensitivität in einem kombinierten System gegenüber Geräten für eine Modalität aufweist. Es sollen Aufnahmen ermöglicht werden, welche bezüglich des PET- bzw. des SPECT-Anteils der MR-PET bzw. MR-SPECT Messung eine erhöhte Empfindlichkeit gegenüber Geräten für kombinierte MR-PET oder MR-SPECT- Messungen nach dem Stand der Technik aufweisen, wobei so wenig wie möglich Artefakte insbesondere keine Einfaltungen in den MRT-Bildern, auftreten sollen. Die technische Lösung der Aufgabe sollte nicht teuer und leicht zu implementieren sein. Die Abschwächung und/oder Streuung von γ-Strahlen oder anderen Photonen, die detektiert werden sollen, soll minimiert werden. Höhere B₀ Felder, wie beispielsweise Ultrahochfeld 7 Tesla bzw. > 7 Tesla sowie Hochfeld ≥3 Tesla sollen der Nutzung leichter zugänglich gemacht werden. Beispielhaft können Magnetfelder von 9,4 Tesla, 10,5, Tesla, 11,7 Tesla, 14 Tesla aber auch 20 Tesla genannt werden. Es soll eine Rückstreuung und Absorption von γ-Quanten reduziert bzw. vermieden werden.

Die Aufgabe wird erfindungsgemäss mit den in den unabhängigen Ansprüchen 1 und 14 angegebenen Merkmalen gelöst.

Damit ist es nunmehr möglich, störungsfreie MRT- PET/SPECT Bilder zu erzeugen, die insbesondere keine Einfaltungen in den MRT Bildern oder Artefakte aufweisen. Die kombinierten Komponenten des erfindungsgemäßen MR-PET/SPECT Tomographen haben eine nahezu identische Qualität, wie sie die einzelnen Komponenten MR, PET und SPECT aufweisen. Die Abschwächung oder Streuung von γ-Strahlen wird vermindert. Eine Verwendung höherer B₀ Felder, wie beispielsweise Ultrahochfeld 7 Tesla bzw. > 7 Tesla, wie von 9,4 Tesla, 10,5, Tesla, 11,7 Tesla, 14 Tesla aber auch 20 Tesla, sowie Hochfeld ≥3 Tesla werden der Nutzung leichter zugänglich gemacht. Es werden Aufnahmen ermöglicht, welche bezüglich des PET- bzw. des SPECT-Anteils der MR-PET bzw. MR-SPECT Messung eine erhöhte Empfindlichkeit der Messung gegenüber diesen Komponenten in MR-PET oder MR-SPECT- Geräten nach dem Stand der Technik aufweisen. Die physische Ausdehnung der Dipolantenne wird verkürzt. Die erfindungsgemäße Lösung der Aufgabe ist kostengünstig und technisch leicht zu implementieren.

Die Bezeichnung MRT-PET/SPECT bedeutet im Folgenden, dass beide Ausführungsformen MRT-PET und MRT-SPECT gemeint sein können.

Vorteilhafte Ausgestaltungen der Erfindung sind in den Unteransprüchen angegeben.

Im Folgenden wird das in der Erfindung verwendete Dipolantennen-Array in seiner allgemeinen Form beschrieben, ohne dass dies einschränkend auszulegen ist. Erfindungsgemäß wird ein Dipolantennen-Array zur Verfügung gestellt, bei dem mindestens 2 Dipolantennenelemente, die an mindestens einer Seite gefaltet sind, in einer Weise zusammengefügt sind, dass sie einen Hohlraum wenigstens teilweise umschließen.

In einer Ausführungsform ist ein Dipolantennenelement des erfindungsgemäßen Dipolantennen-Arrays an einem Ende vorteilhaft um einen Winkel von ≥ 90° bis 180° gefaltet, wobei sich die Anschlüsse und Bauteile an denen das Dipolantennen-Array angeschlossen ist, in der Faltung, außerhalb des Messbereichs der PET-SPECT-Sensoren, welche durch die Breite der Anordnung von PET- oder SPECT-Sensoren im PET/SPECT-Ring entlang dessen Rotationsachse gegeben ist, befinden. In einer weiteren Ausführungsform ist ein Dipolantennenelement auch an beiden Enden gefaltet.

Die Verbindung von Anschlüssen und Bauteilen außerhalb der PET-SPECT-Messbereichs, insbesondere in der Faltung der Dipolantennenelemente, hat zur Folge, dass im PET/SPECT Messbereich keine Störung der Messung stattfindet. Vorteilhaft dabei ist weiterhin, dass damit außerhalb des PET/SPECT- Messbereichs ebenfalls weitere elektronische Bauteile, z.B. Anpassungsschaltungen, Sende-/Empfangsschalter oder Vorverstärker nahe des Einspeisepunktes der Antenne angeordnet werden können, ohne die PET/SPECT-Messungen zu beeinflussen. γ-Quanten können nicht mehr von im PET/SPECT-Messbereich befindlichen Vorrichtungsteilen absorbiert werden, was die Streuung der γ-Quanten an diesen Teilen verhindert. Die γ-Quanten haben typischerweise eine Energie von 511 keV.

Die Faltung der Dipolantennen-Arrays hat zur Folge, dass die räumliche Ausdehnung des Dipolantennen-Arrays verkürzt ist, was in dem begrenzten freien Volumen von hybriden MR-PET/SPECT Geräten vorteilhaft ist. Gleichzeitig führt eine zweckmäßige Faltung, beispielsweise in Form eines "J", dazu, dass die von dem Dipolantennen-Array in diesem Bereich abgestrahlten elektromagnetischen Felder durch geometrisch antiparallel verlaufende Ströme reduziert werden. Dies reduziert die Kopplung des Dipols zu Bauteilen in der Nähe des Einspeisepunktes und die Anregung von kernmagnetischen Resonanzen in diesem Bereich, was verhindert werden soll. Insbesondere mit dem Verhindern der Anregung von kernmagnetischen Resonanzen in dem gefalteten Bereich der Dipolantenne können Artefakte in den MRT-Bildern, beispielsweise durch Einfaltung, verhindert werden.

Die Faltung der Dipolantennenelemente des Dipolantennen-Arrays, welche sich außerhalb des PET/SPECT-Messbereichs befindet, ermöglicht einen leistungsangepassten elektrischen Anschluss des Dipols, der durch das Dipolantennen-Array ausgebildet wird. Das ermöglicht den leistungsangepassten Anschluss unter Verwendung eines Kondensators durch die korrekte Auswahl der elektrischen Anschlusspunkte. Die sinnvolle Auswahl der Anschlusspunkte ergibt sich aus dem Wissen des Fachmanns.

Sollte der Anschluss räumlich nahe des PET/SPECT Messbereichs liegen, so kann eine Rückstreuung von γ-Quanten in den PET/SPECT Messbereich durch eine geringere Anzahl verwendeter Bauteile reduziert werden.

Der gefaltete Bereich Bereich des Dipolantennenelements umfasst eine Biegung, den abgebogenen Längenbereich, sowie der Bereich der senkrechten Projektion des abgebogenen Bereichs auf die Länge des Dipolantennenelements.

Die Biegung kann eine Rundung in Form eines Kreisabschnitts, einer Ellipse oder einer Biegung anderer Geometrie sein. Es ist auch ein Knick des Dipolantennen-Arrays möglich, der einen erfindungsgemäßen Winkel einschließt. Die Biegung kann sich auch aus mindestens zwei Teilbiegungen zusammensetzen.

Der abgebogene Teil ist der Teil, der nach der Biegung in einem Winkel von ≥ 90° und 180° rückläufig zur Längsrichtung der Dipolantenne ist.

Der Bereich der senkrechten Projektion des abgebogenen Bereichs auf die Länge des Dipolantennenelements ist der Abschnitt des Dipolantennenelements, der sich in Längsrichtung vor der Biegung befindet und bei dem die Projektion des abgebogenen Bereichs die senkrecht zur Längsrichtung des Dipolantennenelements steht, abgebildet wird.

Als Endpunkte werden die beiden Enden eines Dipolantennenelements bezeichnet, also das Ende des geraden Teils und das Ende des abgebogenen Bereichs sowie im Falle der Ausführungsform, bei der an beiden Enden des Dipolantennenelements eine Faltung ist, die Endpunkte der beiden Faltungen.

Der Messbereich des erfindungsgemäßen Dipolantennen-Arrays bzw. eines Dipolantennenelements kann sich in dem Bereich zwischen dem Endpunkt, der keine Biegung aufweist und dem Punkt entlang der Länge des Dipolantennen-Arrays befinden, der sich durch die Projektion des Endpunktes des abgebogenen Teils auf die Längsrichtung ergibt. In einer Ausführungsform, bei der beide Enden eines Dipolantennenelements gefaltet sind, kann sich der Messbereich zwischen den Punkten befinden, welche sich durch die Projektion des Endpunktes des jeweils abgebogenen Teils auf die Längsrichtung ergeben. Dieser Messbereich kann wenigstens ein Teilbereich des genannten Längenabschnittes des Dipolantennen-Arrays oder Dipolantennenelements sein und hängt auch von äußeren Faktoren, wie der Ausgestaltung des MR-PET oder ME-SPECT Gerätes oder dem Magnetfeld ab. Es handelt sich dabei um den Längenabschnitt, der als Sender und Empfänger dienen kann. Der Messbereich eines Dipolantennenelements bzw. des Dipolantennen-Arrays ist dann mindestens ein Teilbereich des Anschnittes eines Dipolantennenelements bzw. des Dipolantennen-Arrays in dem sich keine Faltung befindet.

Insbesondere befinden sich im PET oder SPECT- Messbereich eines Dipolantennenelements oder des Dipolantennen-Arrays keine Anschlüsse, wie Induktivitäten, Kondensatoren, Anschlussleitungen, Koaxialkabel oder Vorverstärker.

Die Anschlüsse oder Bauteile befinden sich vorzugsweise wenigstens teilweise in der Faltung des Dipolantennenelements bzw. des Dipolantennen-Arrays.

Vorzugsweise befinden sich alle Anschlüsse und Bauteile in der Faltung des Dipolantennen-Arrays bzw. eines Dipolantennenelements. Dadurch wird eine bessere Bildqualität der PET bzw. SPECT Aufnahme erreicht.

Bei einer bevorzugten Ausgestaltung können beispielsweise Koaxialkabel so angeschlossen werden, dass ihre Enden auf dem abgebogenen Bereich der Faltung und am Bereich der senkrechten Projektion des abgebogenen Bereichs auf die Länge des Dipolantennenelements verteilt sind. Dadurch wird auch ein leistungsangepasster Anschluss unter Verwendung eines einfachen Kondensators durch die korrekte Auswahl der elektrischen Anschlusspunkte ermöglicht.

Der Winkel, mit dem das Dipolantennen-Array bzw. ein Dipolantennenelement gefaltet ist, kann jeden beliebigen Wert innerhalb des Bereichs 90° und 180° aufweisen. So kann er beispielsweise 95°, 100°, 115° 120°.......165°, 170°, 175° oder 179° betragen.

Ein Dipolantennenelement des Dipolantennen-Arrays hat zwischen seinen Endpunkten eine Länge, die λ/2 der Wellenlänge bei der Resonanzfrequenz entspricht. Die physikalische Länge von λ/2 kann nach unteren oder oberen Werten abweichen, soweit eine Funktionsweise beibehalten wird, bei der eine dipolförmige Stromverteilung auf den Dipolantennen-Array bzw. Dipolantennenelement aufrechterhalten wird.

Ein Dipolantennenelement hat vorzugsweise einen Querschnitt, der keine sprunghafte Änderung der Absorptionskoeffizienten für γ Strahlung bewirkt, beispielsweise einen kreisförmigen oder elliptischen Querschnitt. Hiermit können Artefakte in der PET/SPECT-Bildrekonstruktion verhindert werden.

Ein Dipolantennenelement des erfindungsgemäßen Dipolantennen-Arrays ist vorzugsweise dünn ausgestaltet. Als dünn im Sinne der Erfindung ist eine Dicke eines Dipolantennenelements gemeint, die der 1 bis 5 Eindringtiefe des Hochfrequenzfeldes in das Dipolantennenelement entspricht.

Das Dipolantennen-Array bzw. ein Dipolantennenelement besteht vorzugsweise aus einem elektrisch leitenden Material, vorzugsweise einem Metall mit einer niedrigen Ordnungszahl, wie Aluminium. Die Verwendung vor Dipolantennenelementmaterialien mit einer niedrigen Ordnungszahl, wie sie bei Aluminium gegeben ist, hat ebenfalls zur Folge, dass Störungen in den PET/SPECT-Messungen und Artefakte in den aufgenommenen Bildern verhindert oder verringert werden. Die Materialauswahl des Leitermaterials für das Dipolantennen-Array stellt einen Kompromiss zwischen elektrischer Leitfähigkeit und niedriger Ordnungszahl dar.

Das erfindungsgemäße Dipolantennen-Array lässt sich vorteilhaft zu einer Mehrkanal MRT Spule kombinieren, z.B. um den MRT Messbereich zu vergrößern.

Erfindungsgemäß sind mindestens zwei Dipolantennenelemente über eine Halterung in einem Array so zusammengefasst, dass sie einen Hohlraum umgrenzen. In der praktischen Anwendung können 2, 3, 4, 5, 6, 7, 8, 9, 10, 11, 12, 13, 14, 15, 16 oder mehr Dipolantennenelemente einen Hohlraum umschließen, der vorzugsweise zylindrisch ist, wobei die Dipolantennenelemente in einem radialen Abstand zu dem fiktiv eingeschlossenen Zylinder angeordnet sind. Die obere Zahl der auf diese Weise angeordneten Dipolantennenelemente ist nur durch praktische Gesichtspunkte beschränkt.

Die Anzahl der verwendeten Dipolantennenelemente kann von der Stärke des Magnetfeldes oder den Abmessungen des zu untersuchenden Objekts abhängen. Beispielsweise können bei der Aufnahme eines Kopfes bei 9,4 Tesla 8 Dipolantennenelemente vorteilhaft sein. Bei der Untersuchung des ganzen menschlichen Körpers können 16 Dipolantennenelemente vorteilhaft sein. Je höher das eingesetzte B₀ Magnetfeld ist, desto größer ist die störende Kopplung zwischen den Dipolantennenelementen und desto weniger Dipolantennenelemente werden vorteilhaft in einem Dipolantennen-Array zusammengeschaltet. Die störende Kopplung zwischen den Dipolantennenelementen kann jedoch auch durch technische Maßnahmen reduziert werden. Diese sind dem Fachmann bekannt.

Die Faltungen der Dipolantennenelemente eines Dipolantennen-Arrays können dabei auf die entgegengesetzten Enden der Längsrichtung verteilt sein, bevorzugt ist es jedoch, die Dipolantennenelemente so in der Halterung anzuordnen, dass sie alle gebogenen Enden auf derselben Seite der Längsrichtung angeordnet sind. Auf diese Weise sind alle Anschlüsse oder Bauelemente am selben Ende des Dipolantennen-Arrays, sodass alle Kabel in die gleiche Richtung aus dem Trägergehäuse heraus geführt werden können.

Bei der Halterung, als Mittel zum Zusammenhalten von Dipolantennenelementen, kann es sich in einer einfachen Ausführungsform um zwei Ringe handeln, welche an deren Innen- oder Außenseite mit den Dipolantennenelementen verbunden sind oder die Dipolantennenelemente können durch Bohrungen in den Ringen verlaufen, so dass sie fixiert sind.

Es ist vorteilhaft, wenn Halterungsringe nicht in den Messbereich des PET-SPECT-Messbereichs ragen.

Als Halterung kann auch ein Zylinder fungieren, an welchen die Dipolantennenelemente mit Mitteln zum Befestigen angebracht sind.

Die Halterung ist vorzugsweise aus einem nicht magnetischem Material bei dem µ annähernd demjenigen von Luft entspricht, vorzugsweise aus Kunststoff.

Ein Teil oder der gesamte Bereich des Dipolantennenelements bzw. des von einem durch eine Halterung zusammengehaltenen Dipolantennen-Arrays kann für MRT Messungen verwendet werden, sodass der Messbereich für MRT größer, gleich oder kleiner als der des PET/SPECT- Systems sein kann.

In der Faltung eines Dipolantennenelements können verschiedene Vorrichtungselemente angeschlossen sein.

Beispielsweise kann eine Speiseleitung über ein Anpassungsnetzwerk angeschlossen sein. Dabei kann ein Symmetrienetzwerk zusammen mit einer Anpassungsschaltung direkt oder über ein Anpassungsnetzwerk angeschlossen sein. Zusammen mit der Anpassungsschaltung kann noch ein Verstimmkreis eingebaut sein.

Die Erfindung betrifft auch ein Magnetresonanztomographie-, insbesondere Hochfeld-/Ultrahochfeld-Magnetresonanztomographie-, Magnetresonanzspektroskopie- oder Kernspinresonanzspektroskopie-System mit integriertem PET oder SPECT System mit der zuvor beschriebenen erfindungsgemäßen Spulenanordnung, die die eingangs gestellten Aufgaben lösen.

Des Weiteren betrifft die Erfindung eine Verwendung des zuvor beschriebenen erfindungsgemäßen Dipolantennen-Arrays als Hochfrequenz-Sende- und/oder Empfangsspule bei der Magnetresonanztomographie, insbesondere Hochfeld-/Ultrahochfeld-Magnetresonanztomographie, Magnetresonanzspektroskopie oder Kernspinresonanzspektroskopie mit integriertem PET oder SPECT System.

Weitere Merkmale und Vorteile der vorliegenden Erfindung werden anhand der nachfolgenden Beschreibung einer Ausführungsform einer Spulenanordnung gemäß der vorliegenden Erfindung unter Bezugnahme auf die beiliegende Zeichnung deutlich.

In den Figuren wird die Erfindung beispielhaft dargestellt.

Es zeigt:
- Fig. 1:: Ein Dipolantennen-Array bei dem die verschiedenen Bereiche oder Punkte dargestellt sind.
- Fig. 2:: Ein Dipolantennen-Array, bei dem Anschlüsse dargestellt sind.
- Fig. 3:: Eine Dipolantennen-Array, bei dem 6 Dipolantennen erfindungsgemäß angeordnet sind.
- Fig. 4:: Eine Aufsicht auf ein Dipolantennen-Array in Längsrichtung
- Fig. 5:: Eine Aufsicht auf ein Dipolantennen-Array in Längsrichtung.
- Fig. 6:: Magnetfeld eines Kugelphantoms
- Fig. 7:: Aufnahme eines Kopfes
- Fig. 8:: Eine Messanordnung mit einem Patienten, dessen Kopf zu vermessen ist.

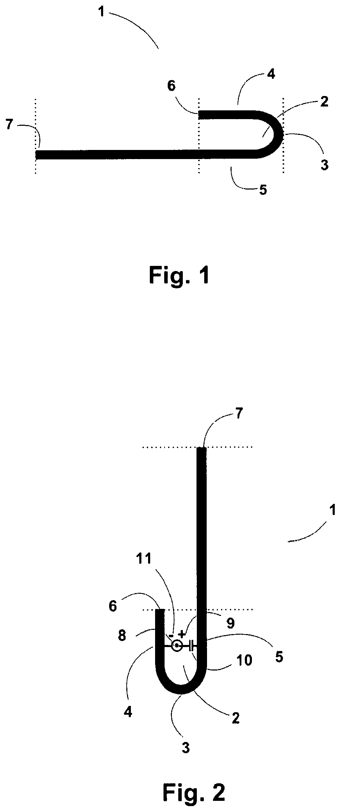

Figur 1 zeigt ein Dipolantennenelement 1 mit einer Faltung 2, die eine Biegung 3, einen abgebogenen Bereich 4, sowie eine Projektion des abgebogenen Bereichs 5 umfasst. Der Endpunkt am gebogenen Bereich trägt das Bezugszeichen 6, und der Endpunkt an der langen Seite des Dipolantennen-Arrays das Bezugszeichen 7.

In Figur 2 ist ein Dipolantennenelement 1 dargestellt, bei dem ein Koaxialkabel 8 mit der Innenleitung 9 an einen Kondensator 10 angeschlossen ist, welcher mit dem Abschnitt des Dipolantennenelements 1 in Verbindung steht, welcher die die Projektion des abgebogenen Bereichs 5 darstellt. Die Außenleitung 11 des Koaxialkabels 8 steht in Verbindung mit dem abgebogenen Bereich 4 in Verbindung.

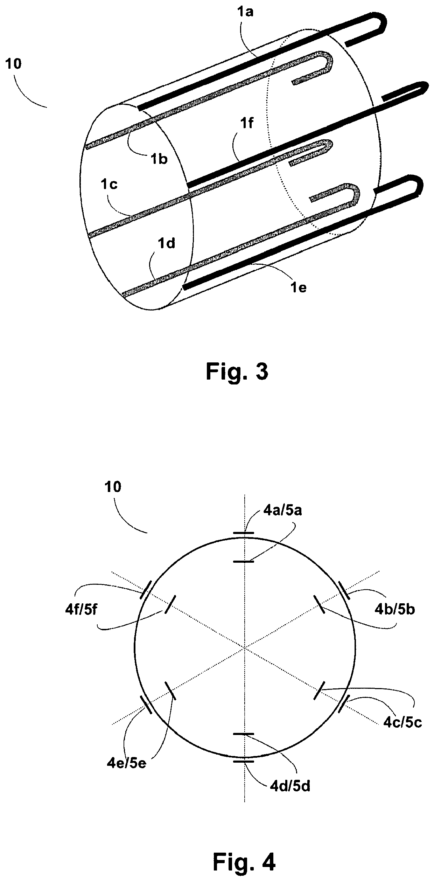

Figur 3 zeigt ein Dipolantennen-Array 10 mit bandförmigen Dipolantennenelementen 1a bis 1f, welche zylinderförmig zueinander angeordnet sind, in einer Aufsicht in Längsrichtung.

Figur 4 zeigt eine Aufsicht in Längsrichtung auf das Dipolantennen-Array 10, bei dem der abgebogene Bereich 4a, 4b,...4f und die Projektion des angebogenen Bereichs 5a, 5b,...5f zu sehen ist.

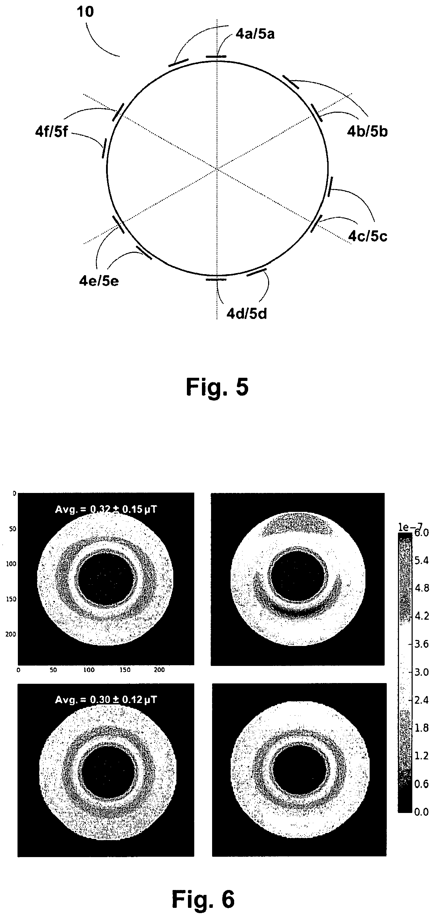

In Figur 5 wird ein Dipolantennen-Array10 als Schnitt dargestellt, bei denen die bei dem der abgebogene Bereich 4a, 4b,...4f und die projektion des angebogenen Bereichs entlang der Oberfläche des zylindrischen Umfangs einer Halterung angeordnet ist.

Figur 6 zeigt das Magnetfeld in einem Kugelphantom bei Verwendung einem erfindungsgemäßen Dipolantennen-Array 10 im Vergleich zu einer linearen Antenne in axialer Richtung und in sagittaler Richtung.

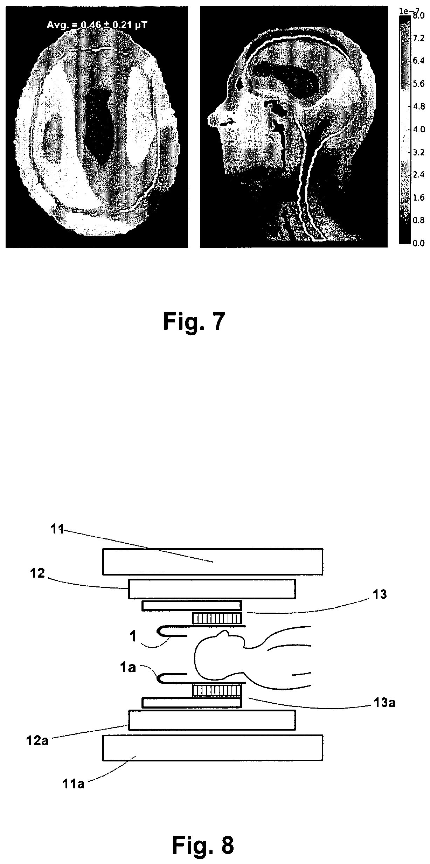

Figur 7 zeigt die Verteilung des Magnetfeldes in einem Kopf bei Verwendung eines erfindungsgemäßen Dipolantennen-Arrays 10 in axialer und in sagittaler Richtung.

Figur 8 zeigt ein MR- PET, bzw. MR-SPECT- Gerät in dem sich ein Patient befindet, dessen Kopf vermessen werden soll. In der Figur ist ein Magnet 11, 11a abgebildet in dem sich eine Gradientenspule 12, 12a befindet. Mit den Bezugszeichen 13, 13a werden für den Fall des MR-PET Gerätes PET Module und im Fall des MR-SPECT-Gerätes SPECT-Module bezeichnet. Dipolantennenelemente, welche Bestandteil des Dipolantennen-Arrays sind haben die Bezugszeichen 1, 1a.

## Patentansprüche

1. Verwendung eines Dipolantennen-Arrays mit mindestens zwei Dipolantennenelementen, bei dem die Dipolantennenelemente (1a), (1b) an einem Ende eine Faltung (2) so dass für jedes Dipolantennenelement ein abgebogener Teil existiert, welcher rückläufig zur Längsrichtung des jeweiligen Dipolantennenelements ist, wobei die Dipolantennenelemente (1a), (1b) einen Hohlraum wenigstens teilweise umschließen, als Antenne in einem MR-PET- oder MR-SPECT-Tomographen, bei der sich die Faltungen (2) der Dipolantennenelemente (1a), (1b) mit Anschlüssen außerhalb des PET- bzw. SPECT-Messbereichs, befinden.

2. Verwendung eines Dipolantennenarrays nach Anspruch 1,
**dadurch gekennzeichnet,**
**dass** die Faltung (2) so ausgebildet ist, dass sie mindestens einen Anschluss von weiteren Komponenten ermöglicht.

3. Verwendung eines Dipolantennen-Arrays nach Anspruch 2,
**dadurch gekennzeichnet,**
**dass** der Anschluss für die Verbindung mit einem Kondensator, elektrische Anschlussleitungen, einem Koaxialkabel, Induktivitäten, Vorverstärker, Anpassungsschaltungen, Sende-/Empfangsschalter, Symmetrienetzwerken, Anpassungsnetzwerke oder Verstimmkreise geeignet ist.

4. Verwendung eines Dipolantennen-Arrays nach einem der Ansprüche 1 bis 3,
**dadurch gekennzeichnet,**
**dass** sich außerhalb der Faltung (2) keine Anschlüsse befinden.

5. Verwendung eines Dipolantennen-Arrays nach einem der Ansprüche 1 bis 4,
**dadurch gekennzeichnet,**
**dass** das Ende der Dipolantennenelemente (1a), (1b) an dem Ende um einen Winkel von ≥ 90° bis 180° gefaltet ist.

6. Verwendung eines Dipolantennen-Arrays nach einem der Ansprüche 1 bis 5,
**dadurch gekennzeichnet,**
**dass** die Faltung (2) durch mindestens eine Biegung (3) gebildet wird, welche durch eine Rundung oder einen Knick verwirklicht ist.

7. Verwendung eines Dipolantennen-Arrays nach einem der Ansprüche 1 bis 6,
**dadurch gekennzeichnet,**
**dass** Anschlüsse für elektrische Bauteile auf den abgebogenen Teil der Dipolantennenelemente und dessen Projektion auf das jeweilige Dipolantennenelement verteilt sind.

8. Verwendung eines Dipolantennen-Arrays nach einem der Ansprüche 1 bis 7,
**dadurch gekennzeichnet,**
**dass** die Dipolantennenelemente (1a), (1b) aus einem Metall einer niedrigen Ordnungszahl bestehen.

9. Verwendung eines Dipolantennen-Arrays nach einem der Ansprüche 1 bis 8,
**dadurch gekennzeichnet,**
**dass** der Querschnitt der Dipolantennenelemente (1a), (1b) senkrecht zur Längsrichtung so ausgebildet ist, dass er keine sprunghafte Änderung von Absorptionskoeffizienten für Gammaquanten bewirkt.

10. Verwendung eines Dipolantennen-Arrays nach einem der Ansprüche 1 bis 9,
**dadurch gekennzeichnet,**
**dass** es 3 bis 16 Dipolantennenelemente (1a), (1b) besitzt.

11. Verwendung eines Dipolantennen-Arrays nach einem der Ansprüche 1 bis 10,
**dadurch gekennzeichnet,**
**dass** mindestens ein Dipolantennenelement (1a), (1b) an beiden Enden gefaltet ist.

12. Verwendung eines Dipolantennen-Arrays nach einem der Ansprüche 1 bis 10,
**dadurch gekennzeichnet,**
**dass** sich alle Faltungen (2) am selben Ende des Dipolantennen-Arrays befinden.

13. Verwendung eines Dipolantennenarrays nach einem der Ansprüche 1 bis 12,
**dadurch gekennzeichnet,**
**dass** es bei der Hochfeld- bzw. Ultrahochfeld-Magnetresonanztomographie eingesetzt wird.

14. MR-PET- oder MR-SPECT- Tomograph mit einem Dipolantennen-Array mit mindestens zwei Dipolantennenelementen, bei dem die Dipolantennenelemente (1a), (1b) an einem Ende eine Faltung (2) aufweisen, so dass für jedes Dipolantennenelement ein abgebogener Teil existiert, welcher rückläufig zur Längsrichtung des jeweiligen Dipolantennenelements ist, wobei die Dipolantennenelemente (1a), (1b) einen Hohlraum wenigstens teilweise umschließen, als Antenne bei der sich die Faltungen (2) der Dipolantennenelemente mit Anschlüssen außerhalb des PET- bzw. SPECT-Messbereichs befinden.

15. MR-PET- oder MR-SPECT-Tomograph nach Anspruch 14,
**dadurch gekennzeichnet,**
**dass** der Anschluss für die Verbindung mit einem Kondensator, elektrische Anschlussleitungen, einem Koaxialkabel, Induktivitäten, Vorverstärker, Anpassungsschaltungen, Sende-/Empfangsschalter, Symmetrienetzwerken, Anpassungsnetzwerke oder Verstimmkreise geeignet ist.

## Claims

1. A use of a dipole antenna array with at least two dipole antenna elements, in which the dipole antenna elements (1a), (1b) have a fold (2) at one end such that, for each dipole antenna element, there is a bent part which deflects back towards the longitudinal direction of the respective dipole antenna element, wherein the dipole antenna elements (1a), (1b) at least partially enclose a cavity, as an antenna in an MR-PET or MR-SPECT tomograph, in which the folds (2) of the dipole antenna elements (1a), (1b) are located with their ports outside of the PET or SPECT measurement range.

2. The use of a dipole antenna array according to claim 1,
**characterized in**
**that** the fold (2) is configured such that it enables at least one port for further components.

3. The use of a dipole antenna array according to claim 2,
**characterized in**
**that** the port is suitable for connection to a capacitor, electrical connection lines, a coaxial cable, inductors, preamplifiers, matching circuits, transmit/receive switches, symmetry networks, matching networks or detuning circuits.

4. The use of a dipole antenna array according to any one of claims 1 to 3,
**characterized in**
**that** there are no ports outside of the fold (2).

5. The use of a dipole antenna array according to any one of claims 1 to 4,
**characterized in**
**that** the end of the dipole antenna elements (1a), (1b) is folded at the end by an angle of ≥ 90° to 180°.

6. The use of a dipole antenna array according to any one of claims 1 to 5,
**characterized in**
**that** the fold (2) is formed by at least one bend (3) which is embodied as a curvature or an elbow.

7. The use of a dipole antenna array according to any one of claims 1 to 6,
**characterized in**
**that** ports for electrical components are distributed across the bent part of the dipole antenna elements and the projection thereof is distributed across the respective dipole antenna element.

8. The use of a dipole antenna array according to any one of claims 1 to 7,
**characterized in**
**that** the dipole antenna elements (1a), (1b) consist of a metal with a low atomic number.

9. The use of a dipole antenna array according to any one of claims 1 to 8,
**characterized in**
**that** the cross section of the dipole antenna elements (1a), (1b) is configured perpendicular to the longitudinal direction such that it does not cause any sudden change in absorption coefficients for gamma quanta.

10. The use of a dipole antenna array according to any one of claims 1 to 9,
**characterized in**
**that** it has 3 to 16 dipole antenna elements (1a), (1b).

11. The use of a dipole antenna array according to any one of claims 1 to 10,
**characterized in**
**that** at least one dipole antenna element (1a), (1b) is folded at both ends.

12. The use of a dipole antenna array according to any one of claims 1 to 10,
**characterized in**
**that** all folds (2) are at the same end of the dipole antenna array.

13. The use of a dipole antenna array according to any one of claims 1 to 12,
**characterized in**
**that** it is employed in high-field and ultrahigh-field magnet resonance imaging.

14. An MR-PET or MR-SPECT tomograph, having a dipole antenna array with at least two dipole antenna elements, in which the dipole antenna elements (1a), (1b) have a fold (2) at one end such that, for each dipole antenna element, there is a bent part which deflects back towards the longitudinal direction of the respective dipole antenna element, wherein the dipole antenna elements (1a), (1b) at least partially enclose a cavity, as an antenna in which the folds (2) of the dipole antenna elements are located with their ports outside of the PET or SPECT measurement range.

15. The MR-PET or MR-SPECT tomograph according to claim 14,
**characterized in**
**that** the port is suitable for connection to a capacitor, electrical connection lines, a coaxial cable, inductors, preamplifiers, matching circuits, transmit/receive switches, symmetry networks, matching networks or detuning circuits.

## Revendications

1. Utilisation d'un réseau d'antennes dipolaires comprenant au moins deux éléments d'antenne dipolaire, dans lequel les éléments (1a), (1b) d'antenne dipolaire ont un pli (2) à une extrémité, de manière à avoir, pour chaque élément d'antenne dipolaire, une partie incurvée, qui revient vers l'arrière par rapport à la direction longitudinale de l'élément d'antenne dipolaire respectif,
dans laquelle les éléments (1a), (1b) d'antenne dipolaire enferment, au moins en partie, une cavité, comme antenne dans un tomodensitomètre RM-PET ou RM-SPECT, dans laquelle les plis (2) des éléments (1a), (1b) d'antenne se trouvent, par des connexions, à l'extérieur du domaine de mesure PET et respectivement SPECT.

2. Utilisation d'un réseau d'antennes dipolaires suivant la revendication 1,
**caractérisée en ce que**
le pli (2) est constitué de manière à permettre au moins une connexion d'autres composants.

3. Utilisation d'un réseau d'antennes dipolaires suivant la revendication 2,
**caractérisée en ce que**
la connexion est appropriée à la liaison à un condensateur, à des lignes électriques de connexion, à un câble coaxial, à des inductances, à un préamplificateur, à des circuits d'adaptation, à un interrupteur d'émission / réception, à des réseaux de symétrie, à des réseaux d'adaptation ou à un circuit d'accord.

4. Utilisation d'un réseau d'antennes dipolaires suivant l'une des revendications 1 à 3,
**caractérisée en ce qu'**
il n'y a pas de connexion à l'extérieur du pli (2).

5. Utilisation d'un réseau d'antennes dipolaires suivant l'une des revendications 1 à 4,
**caractérisée en ce que**
l'extrémité des éléments (1a), (1b) d'antenne dipolaire est pliée à l'extrémité d'un angle ≥ 90° à 180°.

6. Utilisation d'un réseau d'antennes dipolaires suivant l'une des revendications 1 à 5,
**caractérisée en ce que**
le pli (2) est formé par au moins un cintrage (3), qui est provoqué par un arrondi ou par une courbure.

7. Utilisation d'un réseau d'antennes dipolaires suivant l'une des revendications 1 à 6,
**caractérisée en ce que**
des connexions de composants électriques sont réparties sur la partie incurvée des éléments d'antenne dipolaire et sa projection sur l'élément d'antenne dipolaire respectif.

8. Utilisation d'un réseau d'antennes dipolaires suivant l'une des revendications 1 à 7,
**caractérisée en ce que**
les éléments (1a), (1b) d'antenne dipolaire sont en un métal d'un petit nombre atomique.

9. Utilisation d'un réseau d'antennes dipolaires suivant l'une des revendications 1 à 8,
**caractérisée en ce que**
la section transversale des éléments (1a), (1b) d'antenne dipolaire, perpendiculairement à la direction longitudinale, est constituée de manière à ne pas provoquer de variation brusque du coefficient d'absorption de quanta gamma.

10. Utilisation d'un réseau d'antennes dipolaires suivant l'une des revendications 1 à 9,
**caractérisée en ce qu'**
elle possède de 3 à 16 éléments (1a), (1b) d'antenne dipolaire.

11. Utilisation d'un réseau d'antennes dipolaires suivant l'une des revendications 1 à 10,
**caractérisée en ce qu'**
au moins un élément (1a), (1b) d'antenne dipolaire est plié aux deux extrémités.

12. Utilisation d'un réseau d'antennes dipolaires suivant l'une des revendications 1 à 10,
**caractérisée en ce que**
tous les plis (2) se trouvent à la même extrémité du réseau d'antennes dipolaires.

13. Utilisation d'un réseau d'antennes dipolaires suivant l'une des revendications 1 à 12,
**caractérisée en ce qu'**
elle est utilisée en tomodensitométrie par résonnance magnétique à grand champ ou à ultra grand champ.

14. Tomodensitomètre RM-PET ou RM-SPECT comprenant un réseau d'antennes dipolaires ayant au moins deux éléments d'antenne dipolaire, dans lequel les éléments (1a), (1b) d'antenne dipolaire ont un pli (2) à une extrémité, de manière à avoir, pour chaque élément d'antenne dipolaire, une partie incurvée, qui revient vers l'arrière par rapport à la direction longitudinale de l'élément d'antenne dipolaire respectif,
dans laquelle les éléments (1a), (1b) d'antenne dipolaire enferment, au moins en partie, une cavité, comme antenne dans un tomodensitomètre RM-PET ou RM-SPECT, dans laquelle les plis (2) des éléments d'antenne se trouvent, par des connexions, à l'extérieur du domaine de mesure PET et respectivement SPECT.

15. Tomodensitomètre RM-PET ou RM-SPECT suivant la revendication 14,
**caractérisé en ce que**
la connexion est appropriée à la liaison à un condensateur, à des lignes électriques de connexion, à un câble coaxial, à des inductances, à un préamplificateur, à des circuits d'adaptation, à un interrupteur d'émission / réception, à des réseaux de symétrie, à des réseaux d'adaptation ou à un circuit d'accord.
